# EUROPEAN PATENT SPECIFICATION

(11) **EP 0 393 996 B1**
(45) Date of publication and mention of the grant of the patent: **14.06.1995**
(21) Application number: 90304119.2
(22) Date of filing: 17.04.1990
(51) Int. Cl.: G11C 27/04, G11C 19/28

(54) **Charge coupled devices**
Ladungsgekoppelte Vorrichtungen
Dispositifs à accouplement de charge

(30) Priority: 17.04.1989 JP 97208/89; 17.04.1989 JP 97209/89
(43) Date of publication of application: 24.10.1990
(73) Proprietor: SONY CORPORATION, Tokyo 141 (JP)
(72) Inventor: Narabu, Tadakuni, c/o Patents Division, Shinagawa-ku, Tokyo 141 (JP); Kondo, Tetsuya, c/o Patents Division, Shinagawa-ku, Tokyo 141 (JP); Maki, Yasuhito c/o Patents Division, Shinagawa-ku, Tokyo 141 (JP); Noguchi, Katsunori, c/o Patents Division, Shinagawa-ku, Tokyo 141 (JP)
(74) Representative: Cotter, Ivan John

(56) References cited:
- EP-A- 0 211 441
- US-A- 4 307 423
- US-A- 4 610 019

## Description

This invention relates to charge coupled devices (CCDs).

In, for example, modern video signal processing apparatus, it has been found necessary to use CCD delay elements in comb filters, in place of the glass delay lines used previously. A glass delay line operates by converting a signal into an acoustic wave which passes through a glass layer, and it is difficult to reduce the size and cost of such a delay line. Moreover, glass delay lines cannot successfully be used in the higher bands now required for video.

In video technology, the current trend is to make the equipment, such as cameras and tape recorders, portable, and this necessitates operation using a low voltage power source. Thus a CCD may need to be driven by power source of, for example, 5V. This leads to difficulty in obtaining a satisfactorily high linearity of the input-output characteristics of a diode cut-off input system used to apply an input signal to a source region of the CCD. For this reason, the need for an improved gate input circuit has increased.

In the gate input circuit, the signal phases of the input signal and the output signal are necessarily reversed. To counter this, an inverting amplifier has to be provided for the input or the output circuit of the CCD. If the inverting amplifier is provided in the output circuit, it has to amplify the signal which has already been amplified by the output amplifier, and this may necessitate a wider dynamic range for the inverting amplifier. It is therefore preferable to provide the inverting amplifier in the input circuit.

However, when such an inverting amplifier is provided, the temperature characteristics of the CCD can be degraded. In particular, the temperature dependency of the delay can increase, which for example affects the characteristics of a comb filter. Basically, there are two different requirements. One is to allow degradation of the temperature characteristics, while obtaining coincident phases of the input and output signals. The other is to prevent degradation of the temperature characteristics, while permitting different signal phases of the input and output signals. As producing two different types of CCD is inefficient and costly, it would be preferred to produce a CCD which satisfies both requirements.

Also, the input bias for a CCD changes, depending upon the phase relationship between the input signal and the output signal. Therefore, it would be preferable to be able to switch the input bias level between different levels.

According to the present invention there is provided a charge coupled device comprising:
a delay line having an input and an output;
an input terminal for receiving an information signal from an information signal source; and
a first input circuit for directly connecting said input terminal to said delay line; characterized by
a second input circuit for connecting said input terminal to said delay line via an inverting amplifier;
a switching means associated with said first and second input circuits for selectively establishing and blocking electrical communication between said information signal source and said delay line so that said information signal source is communicated with said delay line via one of said first and second input circuits; and
an input bias point setting means which comprises a first setting circuit for setting an input bias at a first bias point, a second setting circuit for setting the input bias at a second bias point different from said first bias point, and a bias switching means for selectively connecting one of said first and second setting circuits to said input terminal.

An embodiment of the charge coupled device may comprise a first signal input path for supplying an information signal to be transferred through a delay line, in which path is connected an inverting amplifier, and a second signal input path having no inverting amplifier. The first and second signal input paths are arranged in parallel with each other. The charge coupled device also has a switching means associated with the first and second signal input paths so as selectively to establish connection between one of the first and second signal input paths and the delay line, so that a non-inverted or an inverted information signal can selectively be supplied to the delay line.

The invention will now be described by way of example with reference to the accompanying drawings, throughout which like parts are referred to by like references, and in which:
Figure 1 is a circuit diagram of an embodiment of CCD according to the present invention;
Figure 2 is a chart showing input/output characteristics of the embodiment of Figure 1;
Figure 3 is a block diagram of an output circuit for the embodiment of Figure 1;
Figure 4 is a timing chart of a sampling pulse generator in the output circuit of Figure 3;
Figure 5 is a timing chart of the output circuit of Figure 3; and
Figure 6 is a block diagram of another output circuit for the embodiment of Figure 1.

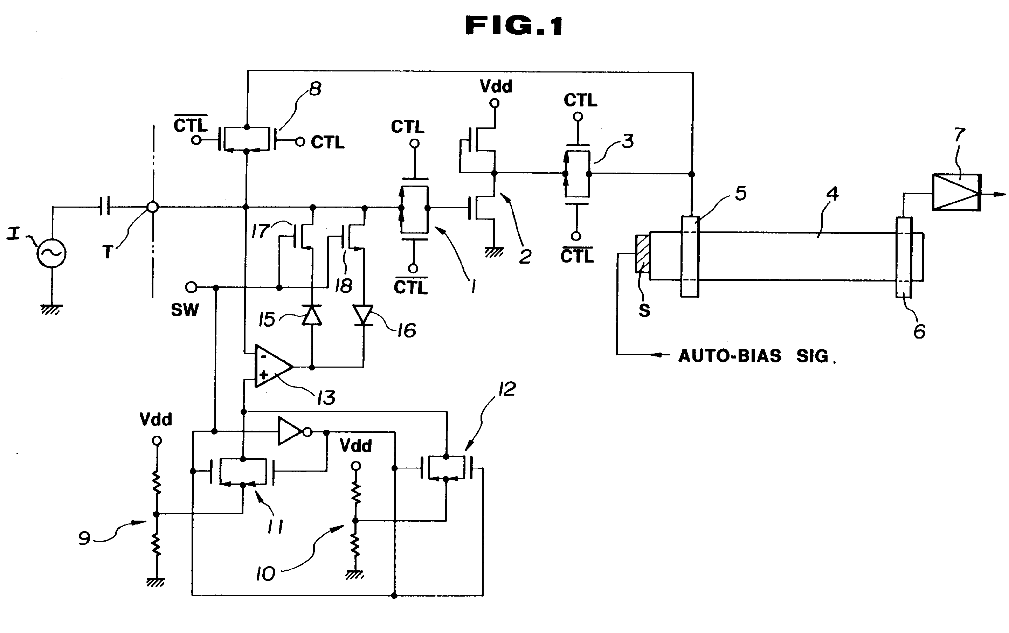

Referring to Figure 1, the embodiment of CCD is associated with an automatic bias system, for automatically adjusting the input bias level. Such an automatic bias system is disclosed in US patent specifications US-A-4 625 322 and US-A-4 139 784 and in European patent specification EP-A-0 147 697.

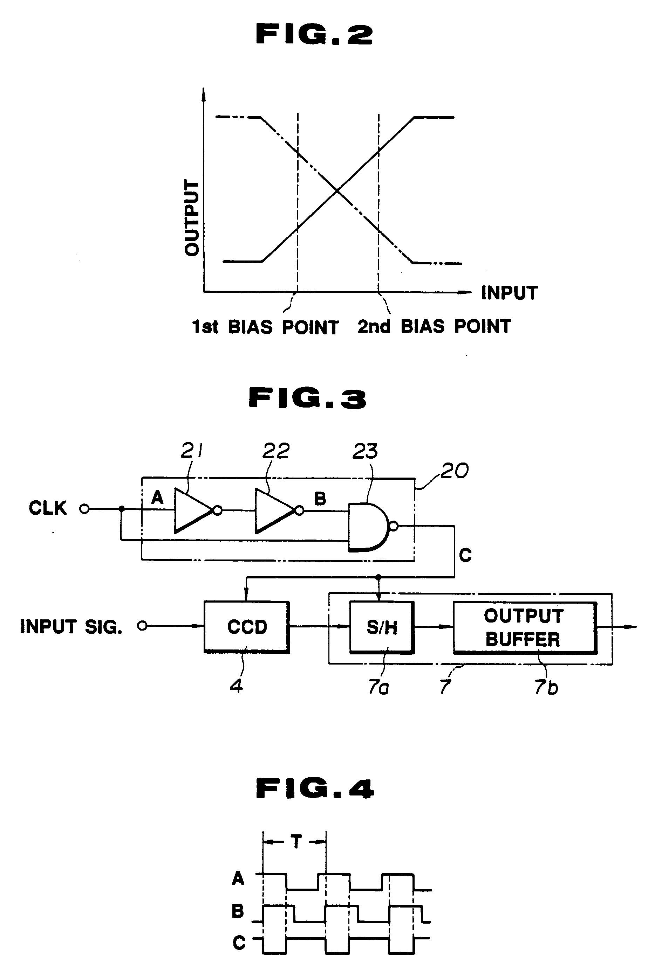

The CCD has an input terminal T externally connected to an information signal source I. The input terminal T is connected to an input gate 5 of a CCD delay line 4 via an inverting amplifier 2. A CMOS switch 1 is provided between the input terminal T and the inverting amplifier 2, for selectively establishing and blocking electrical communication therebetween. Another CMOS switch 3 is disposed between the inverting amplifier 2 and the input gate 5. The information signal transferred through the delay line 4 is supplied through an output gate 6 to an output circuit 7. As shown in Figure 3, the output circuit 7 comprises a sample/hold circuit 7a and an output buffer 7b. The delay line 4 has a source region S to which an automatic bias signal from the aforementioned automatic bias system is applied, for automatically adjusting the input bias level.

A by-pass path by-passing the inverting amplifier 2 is provided for direct connection between the input terminal T and the input gate 5. A CMOS switch 8 is disposed in the by-pass path for selectively establishing and blocking electrical communication between the input terminal T and the input gate 5.

A bias level setting circuit is also provided for adjusting an input bias level. This includes voltage dividers 9 and 10 for setting respective clamp levels which are different from each other. The outputs of the voltage dividers 9 and 10 are connected to the non-inverting input terminal of a differential amplifier 13 via CMOS switches 11 and 12. The inverting input terminal of the differential amplifier 13 is connected to the input terminal T. The output terminal of the differential amplifier 13 is connected to the anode of a diode 15 and to the cathode of a diode 16. The cathode of the diode 15 is connected to the input terminal T via a p-channel MOS transistor 17, while the anode of the diode 16 is connected to the input terminal T via an n-channel MOS transistor 18.

The CMOS switches 1, 3 and 8 are controlled by a control signal CTL and an inverted control signal C̅T̅L̅. When the signal CTL is of HIGH level, the CMOS switch 8 becomes conductive to establish direct communication between the input terminal T and the input gate 5 via the by-pass path. The CMOS switches 1 and 3 are then held non-conductive to block electrical communication therethrough. On the other hand, when the signal C̅T̅L̅ is of HIGH level, the CMOS switches 1 and 3 are conductive to establish communication between the input terminal T and the input gate 5 via the inverting amplifier 2.

The transistors 17 and 18 and the CMOS switches 11 and 12 are switched by a bias level switching signal SW and an inverted bias level switching signal. The CMOS switch 11 and the p-channel transistor 17 are conductive in the presence of the HIGH level inverted bias level switching signal. At this time, the bias level is set at a level set by the voltage divider 9. On the other hand, when the non-inverted bias switching signal SW is of HIGH level, the CMOS switch 12 and the n-channel transistor 18 are conductive for setting the bias level at a level set by the voltage divider 10.

With this construction, the embodiment has input/output characteristics as illustrated in Figure 2, in which the input/output characteristics while the inverting amplifier 2 is active for making the signal phases of the input and output signals the same is shown by the solid line, while the input/output characteristics while the inverting amplifier 2 is not active for making the signal phases of the input and output signals different, is shown by a two-dotted line. In addition, as can be seen, the embodiment may provide two different bias levels.

The first bias point is selected when both of the input and output signals are of positive phase. Also, the first bias point is selected when the input signal is of positive phase and the output signal is of negative phase. On the other hand, when both of the input and output signals are of negative phase, the second bias point is selected. Also, when the input signal is of negative phase and the output signal is of positive phase, the second bias point is selected.

As will be appreciated, the phase relationship between the input and output signals can be selected simply by the control signal level. Furthermore, the input bias point can be selected by the bias level setting circuit.

As set out in the above introduction, the presence of an inverting amplifier may cause variation in the delay with temperature. It is of course preferred to compensate for such variation. For satisfactorily compensating for temperature, the embodiment employs a sampling timing control at the input and output. This includes a sampling pulse generator circuit 20 which is connected to a clock generator to receive therefrom a clock pulse CLK. The sampling pulse generator circuit 20 comprises a pair of inverters 21 and 22 which form a delay circuit, and a NAND gate 23. The sampling pulse generator circuit 20 supplies a sampling pulse signal which serves as an input sampling pulse signal for the CCD delay line 4 and as an output sampling pulse signal for a sample/hold circuit 7A in the output circuit 7. The sampling of the input signal is performed in response to the trailing edge of a sampling pulse, and sampling of the output signal is performed in response to the leading edge of a sampling pulse.

Here, the output buffer 7b is formed of FETs which have variable conductance gm depending on the temperature; the conductance gm falling with a rise in temperature. Therefore, the delay time τₚ of the output buffer 7b increases with a rise in temperature. This can be compensated by shortening the interval between the input sampling timing and the output sampling timing. To achieve this, the sampling pulse width has to be expanded.

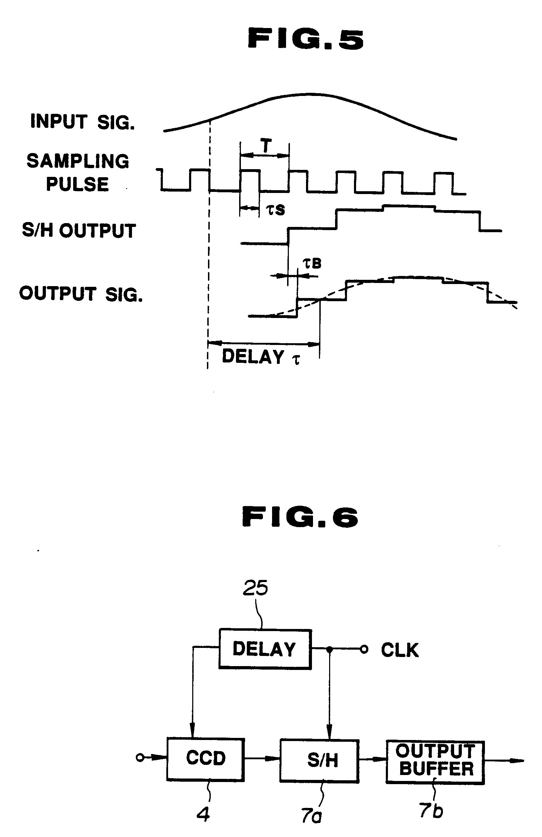

Adjustment of the sampling pulse width with the temperature can be done automatically by the sampling pulse generator circuit 20. Namely, the NAND gate 23 has one input terminal to which the clock pulse CLK, as illustrated in Figure 4A is directly applied, while a pulse delayed by the inverters 21 and 22 are shown in Figure 4B, is applied to the other input terminal of the NAND gate 23. By this, the sampling pulse as illustrated in Figure 4C is supplied from the NAND gate 23. Assuming the duty circle of the clock pulse CLK is 50%, and further assuming that the delay in the inverters 21 and 22 is zero, the duty cycle of the sampling pulse becomes 50%. Delay in the inverters 21 and 22 may cause increase of the duty cycle of the sampling pulse to greater than 50%. Since the inverters 21 and 22 are influenced by the same temperature as that influencing the output buffer 7b, the sampling pulse width can be adjusted automatically. Therefore, as shown in Figure 5, the delay time τ can be adjusted by the pulse width τₛ of the input/output sampling pulse, variation of which causes variation of the duty cycle of the sampling pulse in relation to the constant pulse period T. In Figure 5, τ_{B} represents the delay time caused by group delay in the output buffer.

Figure 6 shows another example of an input and output sampling timing control circuit to be employed in the embodiment of CCD. In this example the clock pulse CLK is applied directly to the sample/hold circuit 7a, and is applied to the CCD delay line via a delay circuit 25. The delay circuit 25 may have temperature dependent characteristics to prevent increase in the delay with rise of temperature. With this circuit, substantially equivalent compensation for fluctuation of the delay as with the former example can be achieved.

## Claims

1. A charge coupled device comprising:
a delay line (4) having an input (5) and an output (6);
an input terminal (T) for receiving an information signal from an information signal source (I); and
a first input circuit (8) for directly connecting said input terminal (T) to said delay line (4); characterized by
a second input circuit (1, 3) for connecting said input terminal (T) to said delay line (4) via an inverting amplifier (2);
a switching means (8, 1, 3) associated with said first and second input circuits (8, 1, 3) for selectively establishing and blocking electrical communication between said information signal source (I) and said delay line (4) so that said information signal source (I) is communicated with said delay line (4) via one of said first and second input circuits (8, 1, 3); and
an input bias point setting means (9, 10) which comprises a first setting circuit (9) for setting an input bias at a first bias point, a second setting circuit (10) for setting the input bias at a second bias point different from said first bias point, and a bias switching means (17, 18) for selectively connecting one of said first and second setting circuits (9, 10) to said input terminal (T).

2. A device according to claim 1 which further comprises a sampling pulse generator (20) for generating a sampling pulse signal defining sampling timings at the input and the output of said delay line (4), said sampling pulse generator (20) having an adjustable duty cycle for compensating temperature dependent error of the delay.

3. A device according to claim 1 or claim 2 wherein said switching means (8, 1, 3) comprises a first switch element (8) disposed in said first input circuit (8) and switchable between a conductive state and a non-conductive state, a second switch element (1, 3) disposed in said second input circuit (1, 3) and switchable between a conductive state and a non-conductive state, said first and second switch elements (8, 1, 3) being oppositely responsive to a control signal level, so that when one of said first and second switch element (8, 1, 3) is in the conductive state, the other is in the non-conductive state.

4. A device according to claim 3 wherein the level of said control signal is set for operating said second switch element (1, 3) into the conductive state when the same signal phase of information signal at the input (5) and the output (6) of said delay line (4) is required.

5. A device according to claim 1 wherein said switching means (17, 18) is operated by a bias switching signal level which is variable depending upon the phase relationship of the information signal at said input (5) and said output (6) of said delay line (4).

6. A device according to claim 2 wherein said output (6) of said delay line (4) includes an output buffer (7b) having a temperature dependent delay characteristic and said sampling pulse generator (20) includes a delay element (25) having a temperature dependent delay characteristic equivalent to that of said output buffer (7a) for effecting automatic adjustment of the duty cycle of said sampling pulse signal with temperature.

## Patentansprüche

1. Ladungsgekoppelte Vorrichtung, umfassend:
eine Verzögerungsleitung (4) mit einem Eingang (5) und einem Ausgang (6);
einen Eingangsanschluß (T) zum Empfang eines Informationssignals von einer Informationssignalquelle (I); und
einen ersten Eingangsschaltkreis (8) zur direkten Verbindung des Eingangsanschlusses (T) zur Verzögerungsleitung (4);
gekennzeichnet durch
einen zweiten Eingangsschaltkreis (1, 3) zur Verbindung des Eingangsanschlusses (T) mit der Verzögerungsleitung (4) über einen invertierenden Verstärker (2);
eine Schalteinrichtung (8, 1, 3), die zur wahlweisen Aufrechterhaltung und Blockierung der elektrischen Verbindung zwischen der Informationssignalquelle (I) und der Verzögerungsleitung (4) mit dem ersten und dem zweiten Schaltkreis (8, 1, 3) in Verbindung steht, so daß die Informationssignalquelle (I) mit der Verzögerungsleitung (4) über einen des ersten und zweiten Eingangsschaltkreises (8, 1, 3) in Verbindung steht; und
eine Eingangsvorspannungspunkteinstelleinrichtung (9, 10), die einen ersten Einstellschaltkreis (9) zur Einstellung einer Eingangsvorspannung an einem ersten Vorspannungspunkt, einen zweiten Einstellschaltkreis (10) zur Einstellung der Eingangsvorspannung an einem zweiten gegenüber dem ersten Vorspannungspunkt verschiedenen Vorspannungspunkt, und eine Vorspannungsschalteinrichtung (17, 18) zur wahlweisen Verbindung eines des ersten und zweiten Einstellschaltkreises (9, 10) mit dem Eingangsanschluß (T) umfaßt.

2. Vorrichtung nach Anspruch 1, weiterhin umfassend:
einen Abtastpulsgenerator (20) zur Erzeugung eines Abtastpulssignals, das die Abtastsynchronisation am Eingang und am Ausgang der Verzögerungsleitung (4) definiert, wobei der Abtastpulsgenerator (20) ein einstellbares Tastverhältnis zur Kompensation temperaturabhängiger Fehler der Verzögerung aufweist.

3. Vorrichtung nach Anspruch 1 oder 2, wobei die Schalteinrichtung (8, 1, 3) ein erstes in dem ersten Eingangsschaltkreis (8) angeordnetes und zwischen einem leitfähigen und einem nichtleitfähigen Zustand schaltbares Schaltelement (8), und ein zweites Schaltelement (1, 3) umfaßt, das in dem zweiten Eingangsschaltkreis (1, 3) angeordnet ist und zwischen einem leitfähigen und einem nichtleitfähigen Zustand schaltbar ist, wobei das erste und das zweite Schaltelement (8, 1, 3) entgegengesetzt auf eine Steuersignalgröße anworten, so daß, wenn eines des ersten und zweiten Schaltelementes (8, 1, 3) im leitfähigen Zustand ist, das andere in einem nichtleitfähigen Zustand ist.

4. Vorrichtung nach Anspruch 3, wobei die Größe des Steuersignals zum Betrieb des zweiten Schaltelements (1, 3) in den leitfähigen Zustand gestellt wird, wenn dieselbe Signalphase des Informationssignals am Eingang (5) und am Ausgang (6) der Verzögerungsleitung (4) benötigt wird.

5. Vorrichtung nach Anspruch 1, wobei die Schalteinrichtung (17, 18) durch eine Vorspannungsschaltsignalgröße betrieben wird, die in Abhängigkeit der Phasenbeziehung des Informationssignals am Eingang (5) und am Ausgang (6) der Verzögerungsleitung (4) veränderbar ist.

6. Vorrichtung nach Anspruch 2, wobei der Ausgang (6) der Verzögerungsleitung (4) einen Ausgangspuffer (7b) mit einer temperaturabhängigen Verzögerungscharakteristik umfaßt, und wobei der Abtastpulsgenerator (20) ein Verzögerungselement (25) mit einer temperaturabhängigen Verzögerungscharakteristik umfaßt, die gleichwirkend zu der des Ausgangspuffers (7a) ist, um eine automatische Einstellung des Tastverhältnisses des Abtastpulssignales mit der Temperatur zu bewirken.

## Revendications

1. Dispositif à couplage de charge comprenant :
une ligne à retard (4) ayant une entrée (5) et une sortie (6) ;
une borne d'entrée (T) pour recevoir un signal d'information à partir d'une source de signal d'information (I) et
un premier circuit d'entrée (8) pour relier directement ladite borne d'entrée (T) à ladite ligne à retard (4);
caractérisé par
un second circuit d'entrée (1, 3) pour relier ladite borne d'entrée (T) à ladite ligne à retard (4) via un amplificateur d'inversion (2) ;
un dispositif de commutation (8, 1, 3) associé avec lesdits premier et second circuits d'entrée (8, 1, 3) pour établir et bloquer de façon sélective une communication électrique entre ladite source de signal d'information (I) et ladite ligne à retard (4) de sorte que ladite source de signal d'information (I) est en communication avec ladite ligne à retard (4) via un desdits premier et second circuits d'entrée (8, 1, 3) ; et
un dispositif de réglage du point de polarisation d'entrée (9, 10) qui comprend un premier circuit de réglage (9) pour régler une polarisation d'entrée sur un premier point de polarisation, un second circuit de réglage (10) pour régler la polarisation d'entrée sur un second point de polarisation différent dudit premier point de polarisation et un dispositif de commutation de polarisation (17, 18) pour relier de façon sélective un desdits premier et second circuits de réglage (9, 10) à ladite borne d'entrée (T).

2. Dispositif selon la revendication 1 qui comprend en outre un générateur d'impulsion d'échantillonnage (20) pour générer un signal d'impulsion d'échantillonnage définissant des temporisations d'impulsions à l'entrée et à la sortie de ladite ligne à retard (4), ledit générateur d'impulsion d'échantillonnage (20) ayant un rapport cyclique ajustable pour compenser une erreur du retard dépendant de la température.

3. Dispositif selon la revendication 1 ou la revendication 2 dans lequel ledit dispositif de commutation (8, 1, 3) comprend un premier élément de commutation (8) disposé dans ledit premier circuit d'entrée (8) et commutable entre un état conducteur et un état non-conducteur, un second élément de commutation (1, 3) disposé dans ledit second circuit d'entrée (1, 3) et commutable entre un état conducteur et un état non-conducteur, lesdits premier et second éléments de commutation (8, 1, 3) étant sensibles de façon opposée à un niveau de signal de commande, de sorte que lorsqu'un desdits premier et second élément de commutation (8, 1, 3) est dans l'état conducteur, l'autre est dans l'état non-conducteur.

4. Dispositif selon la revendication 3 dans lequel le niveau dudit signal de commande est réglé pour actionner ledit second élément de commutation (1, 3) dans l'état conducteur lorsque la même phase de signal du signal d'information est requise sur l'entrée (5) et la sortie (6) de ladite ligne à retard (4).

5. Dispositif selon la revendication 1 dans lequel ledit dispositif de commutation (17, 18) est actionné par un niveau de signal de commutation de polarisation qui est variable en fonction de la relation de phase du signal d'information sur ladite entrée (5) et ladite sortie (6) de ladite ligne à retard (4).

6. Dispositif selon la revendication 2 dans lequel ladite sortie (6) de ladite ligne à retard (4) comprend un circuit tampon de sortie (7b) ayant une caractéristique de retard dépendant de la température et ledit générateur d'impulsion d'échantillonnage (20) comprend un élément à retard (25) ayant une caractéristique de retard dépendant de la température équivalente à celle dudit circuit tampon de sortie (7a) pour effectuer un réglage automatique du rapport cyclique dudit signal d'impulsion d'échantillonnage avec la température.
